## Europäisches Patentamt
## European Patent Office
## Office européen des brevets

(19)

(11) Publication number: **0 030 641**
**A2**

# (12) EUROPEAN PATENT APPLICATION

(21) Application number: **80107217.4**

(22) Date of filing: **20.11.80**

(51) Int. Cl.³: **H 01 B 3/04**
**H 01 B 3/30**

(30) Priority: **17.12.79 US 104338**

(43) Date of publication of application:
**24.06.81 Bulletin 81/25**

(84) Designated Contracting States:
**DE FR GB IT**

(71) Applicant: **International Business Machines Corporation**

**Armonk, N.Y. 10504(US)**

(72) Inventor: **Escott, Barnee Minna**
**P.O. Box 5696**
**Austin Texas 78703(US)**

(72) Inventor: **Wheater, Robin Anne**
**14 Cindy Lane**
**Essex Junction Vermont 05452(US)**

(74) Representative: **Oechssler, Dietrich, Dr.rer.nat. Dipl.-Chem.**
**Schönaicher Strasse 220**
**D-7030 Böblingen(DE)**

(54) Insulating coating for ceramic substrate and method to form such a coating.

(57) The blanket or selective coating consists of polyimide (12) and of between about 28 and about 84% by weight of mica platelets (10).

To produce the coating a solution of a polyamic acid containing between about 9% and about 45% by weight of mica is applied to the substrate (14) either uniformly or through a screen having a desired pattern. The solvent is removed and the resulting layer is cured into a solid adhering coating.

The coating is preferably used to insulate current-carrying metal patterns disposed on ceramic substrates onto which silicon chips with integrated circuits are mounted.

EP 0 030 641 A2

./...

FIG. 1

INSULATING COATING FOR CERAMIC SUBSTRATE

The invention relates to a thin insulating coating on a ceramic substrate and to a method to produce such a coating.

In the production of integrated circuits, a ceramic substrate material is often used to mount the silicon chips on which are formed the integrated circuits. The ceramic substrate typically has a layer of metal lines applied which act as current carrying wires for electrical current. In many cases it is necessary to provide a layer of electrically insulating material over the metal lines.

In applying such an electrically resistive material to the surface of the chip, it is necessary that the applied material have sharply defined edges or pattern shape so the chips can be bonded, have good adherence to the substrate, and, of course, provide the necessary electrical insulation over the metal wires on the surface.

The object of the invention is to provide a thin insulating coating that adheres very strongly to a ceramic substrate and has well defined lateral dimensions and sharp edges and to a simple method reproducibly to produce such a coating.

These objects are achieved by a coating as defined at the beginning of this specification having the features of the characterizing part of claim 1 and by a method using the features of the characterizing part of claim 5 to produce such a coating.

The advantages of the invention become particularly apparent if the coating covers the ceramic substrate selectively according to a predetermined pattern. The electrically resistive coating adheres very well to the substrate and the pattern elements show a shape with sharp edges. The coating is well suited for insulating the current carrying metal patterns disposed on the ceramic substrate. The mica flakes in the polyamic acid solution have the effect that an exeptional

BU 979 OO7

flow control of the solution is achieved. Since the inventive method allows to produce even complex insulative patterns reproducibly within small tolerances the necessity of etching the desired patterns as in the prior art is eliminated. To coat the substrates selectively a screen preferably having the desired pattern is used to apply the solution onto the substrate.

Other adventageous embodiments of the inventive coating and the inventive method are disclosed in the subclaims.

The invention will become more apparent from the following detailed description taken in conjunction with the accompanying drawings.

Fig. 1    is a sectional illustration showing a coating formed according to the present invention formed of a material consisting of about 9% mica and 91% solution of polyimide resin;

Fig. 2    is a view of a coating on a substrate, similar to Fig. 1, but formed of a material consisting of 31% mica and 69% polyimide resin solution; and

Fig. 3    is a view of a coating on a substrate, similar to Fig. 1, but formed of a material consisting of about 43% mica flakes and 57% solution of polyimide resin.

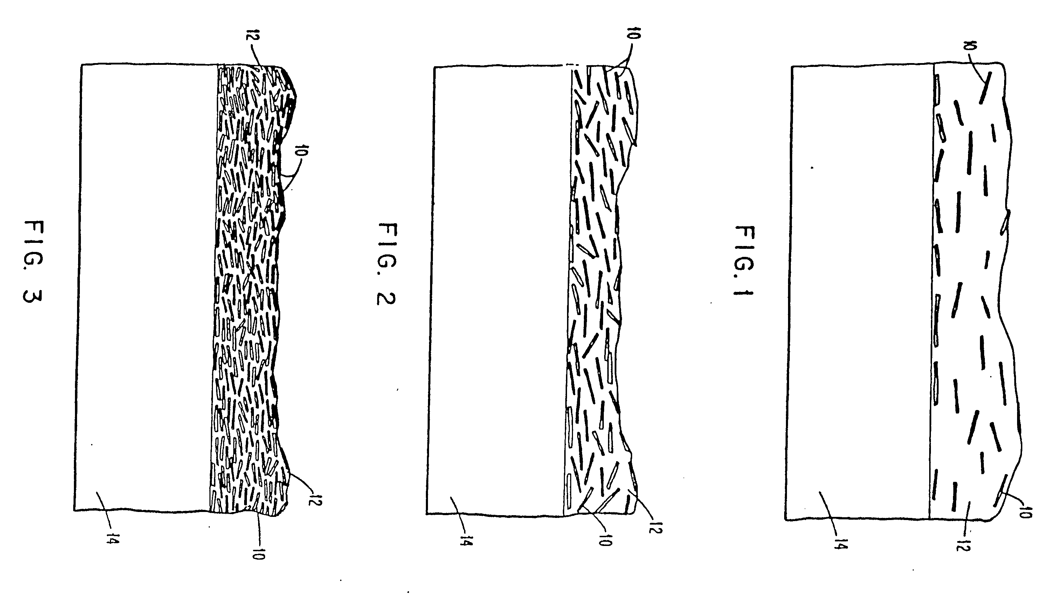

The present invention is specifically directed toward a coating and the method for making such coating of insulating material on a ceramic substrate over metal lines or wire laid down for providing insulation for this metal pattern laid down onto the ceramic substrate. The ceramic substrate with the metal pattern and the overlying insulating material is utilized as a substrate on which silicon chips having integrated circuitry are bonded.

In forming the pattern or layer of electrically insulating material on the substrate, it is necessary

BU 979 007

that a resultant layer of material be firmly adhering to the substrate so that it does not delaminate therefrom in use. It is also essential that the material can be easily applied and has good, sharp, edge definition so that there is a clear sharply defined pattern inscribed on the ceramic substrate to allow for placement of the chip. One conventional process for applying insulating material to such a substrate is the screening process wherein a paste or slurry or suspension of material is forced through the openings of a screen onto the ceramic substrate, the screens being formed into a mask of the desired resulting pattern. The material so screened onto the substrate is then allowed to cure or dry or otherwise harden in the desired pattern. Of course, a material to be suitable for use in the screening process must be able to pass through the screen freely without clogging the screen. The material must also be of the proper consistency or viscosity to adhere to the substrate in the pattern delineated by the screen without either running or bleeding around the edges and without balling up and causing blurring of the edges. This paste or material, of course, must also have the proper characteristics to apply uniformly and maintain a general uniformity of conformation while being applied.

After material has been applied, it is necessary to let the material cure to form a coating with good electrical resistance and good adherence to the substrate and that it be compatible with a silicon chip which may be mounted thereon.

It has been found that a material which meets all of the above characteristics is a solution of a polyimide having dispersed therein from about 9% to about 45% by weight mica flakes. The mica flakes are mixed into the solution of polyimide resin which

BU 979 007

is a solution of a polyamic acid in an organic solvent such as, for example, n-methyl 2-pyrrolidone. The mica flakes are thoroughly distributed and dispersed within a resin solution and the solution with the mica flakes is applied through a screen formed in the desired pattern to a ceramic substrate. Once the solution has been applied the solvent is removed to cure the resulting layer into a solid adhering coating. Curing may be done at elevated temperatures to increase the speed of the cure as is well known in the art.

It has been found that the size and the size distribution of the mica particles is not critical. The only requirement is that they be sufficiently small to pass through the openings of whatever screen size has been selected to be utilized in the screening process without causing clogging. It has been found, however, that there must be at least 9% mica particles by weight based on the weight of the resin solution. If there is less than 9% of mica particles or flakes in the starting material, it has been found that a good resolution of the edges of the pattern cannot be achieved. Such a material either runs excessively giving a poor edge definition or if the amount of solvent is reduced in an attempt to lower the tendency of running, the material becomes so gummy and sticky that it cannot be adequately screened. Thus, the 9% minimum is absolutely required in order to provide a material which is sufficiently fluid to be applied, but has sufficient consistency to hold its configuration without running after it has been screened. Thus, 9% mica by weight is necessary irrespective of the adjustment of the amount of solvent and polyamic acid.

It has also been found that there cannot be any more than about 45% by weight of mica flakes or particles in the starting resin. If the amount of mica particles does exceed about 45%, very poor adherence is achieved between the resulting coating and the ceramic substrate material, i. e., the resulting coating tends to easily delaminate or peel off which, of course, constitutes an unacceptable coating. Also with any more than 45% by weight of mica, the material is too thick to be properly screened.

The reason that this particular coating screens well with well defined edges and yet has good adherence to the substrate is not completely understood. However, it is believed that it is a function of the platelet like structure of the mica. As can be seen in the figures, the mica platelets designated by reference character 10 are distributed in substantial alignment within the polyimide matrix 12 and lie substantially parallel to the ceramic substrate 14. This is the preferred or low entropy configuration of the platelets and in this interleafing or flat-type configuration they tend to act as a barrier or a dam to prevent the running or spreading of the more fluid polyimide before it is cured. Also, of course, the polyimide resin acts as a binder to bind together the flakes of mica to form a uniform coating of high electrical resistance.

It should be noted that the action of the mica flakes is not a thixotropic action nor indeed is it merely a thickening which could occur from spherical particles such as colloidal silica or borax. The action rather is attributed to the plate-like nature of the mica and the electrical resistance is, of course, attributed to the high electrical resistance of the mica as well as the high electrical resistance of the polyimide resin.

BU 979 007

The exact composition of the polyimide and the exact solution strength is not of critical nature, and indeed different types of polyimide solutions have been utilized with good success.

The polyimide resin which can be used as a starting material may vary. For example, the DuPont PI2540 has 16% solids and 84% solvent; whereas, the DuPont PI2525 has 27% solids and 73% solvent. The solvent for the polyamic acid is n-methyl 2-pyrrolidone. It is also possible to use acetone to modify the polyamic acid chain structure, and change the viscosity slightly while still maintaining the ratio of 9% to 45% mica by weight.

The following examples of materials were used to screen onto ceramic substrate and cure into coatings.

## EXAMPLE I

18.2 gms flake mica
40.3 gms DuPont PI2540

This constitutes 31.1% mica.
This composition screened well with excellent edge definition and cured to an excellent adhering coating.

## EXAMPLE II

27.0 gms flake mica
36.4 gms DuPont PI2540

This constitutes 42.6% mica.
This composition screened adequately, although it was quite viscous; with good edge definition; there was adequate adherence after curing, although there was some tendency toward incipient peeling at the edges.

### EXAMPLE III

·10 gms flake mica
100 gms DuPont PI2525

This constitutes 9.1% mica.

This composition screened adequately, and cured to a pattern having adequate edge definition, although there was some loss of sharpness at the edges. The coating adhered very well.

### EXAMPLE IV

20 gms flake mica
100 gms DuPont PI2525

This constitutes 16.67% mica.

This composition screened well and cured to a pattern having quite good edge definition. The coating adhered very well.

### EXAMPLE V

18.2 gms flake mica
20.9 gms DuPont PI2540

This constitutes 46.6% mica.

This composition did not screen adequately, and after curing the coating readily delaminated.

While the broader range of 9% to 45% weight of mica is operable, a preferred more narrow range of about 16% to 40% is even more desireable and a weight of about 31% by weight of mica flakes provides an optimum screening composition.

As can be seen, the percentage of mica is not a function of the solids content per se. This is true because the limitation of the mica at its lower end is not a limitation based peculiarly on amount of solids, but it is based on how well the mica will prevent smearing or flowing of the material as it is applied to the substrate. Also, at the higher end, the limitation is on the amount of mica which will still permit screening of the material as well as providing the enhanced coating. Thus, while there may be some relationship between the mica and the solids content in the form of the polyamic acid exclusive of the solvent, nevertheless the amount of mica is based on the starting material of the polyamic acid and the solvent.

PATENT CLAIMS

1. Thin insulating coating on a ceramic substrate (14) characterized in that the coating consists of polyimide (12) and of between about 28% and about 84% by weight of mica.

2. Coating according to claim 1 containing between about 41% and about 81% by weight of mica.

3. Coating according to claim 1 or 2 containing between about 62% and about 74% by weight of mica.

4. Coating according to any one of claims 1 to 3 that covers the substrate (14) selectively.

5. Method to form a coating according to any one of claims 1 to 4, wherein a solution of a polyamic acid containing between about 9% and about 45% by weight of mica is supplied to the ceramic substrate (14) and then the solvent is removed and the resulting layer is cured into a solid adhering coating.

6. Method according to claim 5 wherein the solution contains between about 16% and about 40% by weight of mica.

7. Method according to claim 5 or 6 wherein the solution contains about 31% by weight of mica.

8. Method according to any one of claims 5 to 7 wherein the solution is screened onto the ceramic substrate through a screen having the desired pattern.

9. Method according to any one of claims 5 to 8 wherein N-methyl-2-pyrolidone and/or acetone is used as solvent in the solution.

BU 979 007

FIG. 1

FIG. 2

FIG. 3